# FASCICULE DE BREVET EUROPEEN

(11) **EP 3 608 727 B1**
(45) Date de publication et mention de la délivrance du brevet: **30.09.2026**
(21) Numéro de dépôt: 18188355.4
(22) Date de dépôt: 09.08.2018
(51) Int. Cl.: G04B 15/14, G04B 31/08, G04B 13/02, B81B 3/00

(54) **COMPOSANT NOTAMMENT HORLOGER AVEC UNE TOPOLOGIE DE SURFACE ET SON PROCÉDÉ DE FABRICATION**
KOMPONENTE, INSBESONDERE FÜR UHRWERK MIT EINER OBERFLÄCHENTOPOLOGIE, UND IHR HERSTELLUNGSVERFAHREN
COMPONENT, IN PARTICULAR FOR A TIMEPIECE, WITH A SURFACE TOPOLOGY AND MANUFACTURING METHOD THEREOF

(43) Date de publication de la demande: 12.02.2020
(73) Titulaire: Nivarox-FAR S.A., 2400 Le Locle (CH)
(72) Inventeur: GANDELHMAN, Alex, 2000 Neuchâtel (CH); CUSIN, Pierre, 1423 Villars-Burquin (CH); VERARDO, Marco, 2336 Les Bois (CH)
(74) Mandataire: ICB SA

(56) Documents cités:
- EP-A1- 3 002 637
- EP-A1- 3 109 199
- EP-A1- 3 109 200
- EP-A1- 3 181 939
- CH-A2- 702 431
- CH-A2- 705 299
- CH-A2- 710 846
- JP-A- 2011 158 050
- JP-A- 2014 051 741

## Description

### DOMAINE TECHNIQUE

La présente invention se rapporte à un composant micromécanique, utilisé notamment dans le domaine horloger, destiné à être soumis, en utilisation, à un contact par frottement avec un autre composant. Elle se rapporte également à son procédé de fabrication.

### ART ANTERIEUR

De nombreux composants horlogers tels que les composants de l'échappement, les sautoirs, ressorts, etc. sont soumis en utilisation au frottement. Traditionnellement, une bonne facture de tels composants veut que leur surface de contact/frottement soit parfaitement lisse. Or, un frottement entre deux corps engendre généralement la formation de particules d'usure formant un troisième corps. Loin d'avoir un effet positif avéré, ce troisième corps peut entraîner une usure accélérée du composant ayant un effet préjudiciable sur sa fonction. Pour éviter cette usure et réduire les forces de frottement qui conduisent à des pertes pour certaines fonctions, une lubrification est appliquée au niveau des surfaces venant en contact de frottement des composants. Cependant, dans la configuration où deux surfaces de frottement parfaitement lisses frottent l'une contre l'autre, le lubrifiant est progressivement évacué des zones de contact/frottement, conduisant à moyen et long terme à une dégradation des conditions de contact de frottement.

On connait du document JP2014051741A un composant présentant une surface de glissement apte à glisser par rapport à un autre composant.

### RESUME DE L'INVENTION

La présente invention a pour objet de remédier aux inconvénients précités en proposant un système de deux composants en contact de frottement dont au moins un composant présente dans la zone destinée à être soumise au frottement une topologie facilitant, d'une part, l'évacuation des particules engendrées par le frottement, et, d'autre part, formant un réservoir pour le lubrifiant.

A cet effet, le composant présente dans ladite zone une structure en forme de vaguelettes. Cette structure définit un ensemble de creusures s'étendant dans la direction du frottement et formant autant de canaux permettant l'évacuation des débris issus du frottement et l'écoulement du lubrifiant. Le système de l'invention est défini par la revendication 1.

Selon l'invention, la structure en forme de vaguelettes est réalisée lors de l'étape d'usinage du composant. Le procédé de fabrication utilisée est le procédé de gravure ionique réactive profonde DRIE (de l'anglais « *Deep Reactive Ion Etching »).* Ce procédé induit la formation de vaguelettes ou ondulations (en anglais « *scalloping* ») sur la tranche usinée du composant. Cette ondulation est un défaut inhérent au procédé que l'homme de métier veut, selon l'état de l'art, supprimer. A cet effet, le procédé DRIE est généralement suivi d'une étape d'oxydation et de désoxydation visant à lisser le profil ondulé. A contrario, selon l'invention, on s'affranchit au moins partiellement de cette étape pour maintenir le profil ondulé qui permet l'évacuation des débris d'usure et sert de réservoir de lubrifiant.

Le procédé de fabrication selon l'invention permet ainsi en une seule étape d'usiner le composant et de texturer la surface. Par ailleurs, l'avantage du procédé selon l'invention est que la texturation en forme de vaguelettes est naturellement alignée dans le sens du frottement sur la tranche usinée. Le procédé de l'invention est défini par la revendication 11.

L'invention se rapporte également à un moule usiné avec le procédé DRIE pour former une structure en forme de vaguelettes sur les flancs usinés du moule. Ces moules avec la texture en forme de vaguelettes forment une empreinte pour la réalisation ultérieure de composants par électroformage. Les composants électroformés présentent ainsi également une texture de forme complémentaire à celle en vaguelettes avec des creusures servant de canaux d'évacuation des débris et de réservoir pour le lubrifiant dans la zone où s'établit le frottement. Le moule est défini par la revendication 10.

Conformément à d'autres variantes avantageuses de l'invention :
- les creusures sont longitudinales et parallèles entre elles.
- lesdites creusures ont une profondeur P qui est supérieure ou égale à 100 nm et inférieure ou égale à 500 nm, et, de préférence, inférieure ou égale à 300 nm.
- la succession de creusures et de crêtes ou de bosses et de creusures forme une structure périodique.
- la texture est présente sur un flanc dudit au moins composant usiné par gravure ionique réactive profonde.
- chacun des deux composants comporte ladite texture sur une surface dans la zone fonctionnelle, lesdites creusures étant disposées en regard l'une de l'autre.
- un seul des deux composants comporte sur sa surface ladite texture, l'autre composant du système présentant une surface lisse dans la zone fonctionnelle.
- ledit au moins un composant est à base de silicium ou à base métallique.
- les deux composants sont des composants horlogers.

D'autres caractéristiques et avantages de la présente invention apparaîtront dans la description suivante de modes de réalisation préférés, présentés à titre d'exemple non limitatif en référence aux dessins annexés.

### BREVE DESCRIPTION DES FIGURES

Les figures 1A et 1B représentent schématiquement un système à deux composants avec un des deux composants comportant sur sa surface de frottement destinée à être partiellement en contact avec l'autre composant une texture en forme d'un train de vaguelettes parallèles entre elles selon l'invention. Le frottement s'établit le long d'une direction longitudinale parallèle à la direction longitudinale des creusures recevant le troisième corps (fig.1A) et le lubrifiant (fig.1B).
Les figures 2A et 2B représentent une variante du système à deux composants avec un des deux composants présentant une texture de forme complémentaire à celle représentée aux figures 1A et 1B.
La figure 3A est une représentation d'un système d'horloger comprenant deux composants (roue d'échappement/ancre) qui présentent sur la tranche des dents et/ou des levées une texture selon l'invention. La figure 3B représente schématiquement la texture sur la tranche usinée.
La figure 4 illustre schématiquement, de manière connue, les différentes étapes du procédé de gravure ionique réactive profonde DRIE.

### DESCRIPTION DETAILLEE

La présente invention se rapporte à des composants à base métallique ou à base de silicium comportant des surfaces destinées à être soumises au frottement en utilisation. La présente invention se rapporte ainsi plus spécifiquement à un système faisant intervenir deux composants comprenant des surfaces soumises au frottement dans une zone dite fonctionnelle. Dans le domaine horloger, il peut, par exemple, s'agir d'un système : roue d'échappement/levées d'une ancre, came/palpeur, cliquet/roue dentée, sautoir/disque, disque d'embrayage/ressort, disque de freinage/sabot, etc. La présente invention se rapporte également aux moules qui permettent de réaliser ces composants par électroformage. Elle se rapporte en outre au procédé de fabrication des composants ou moules.

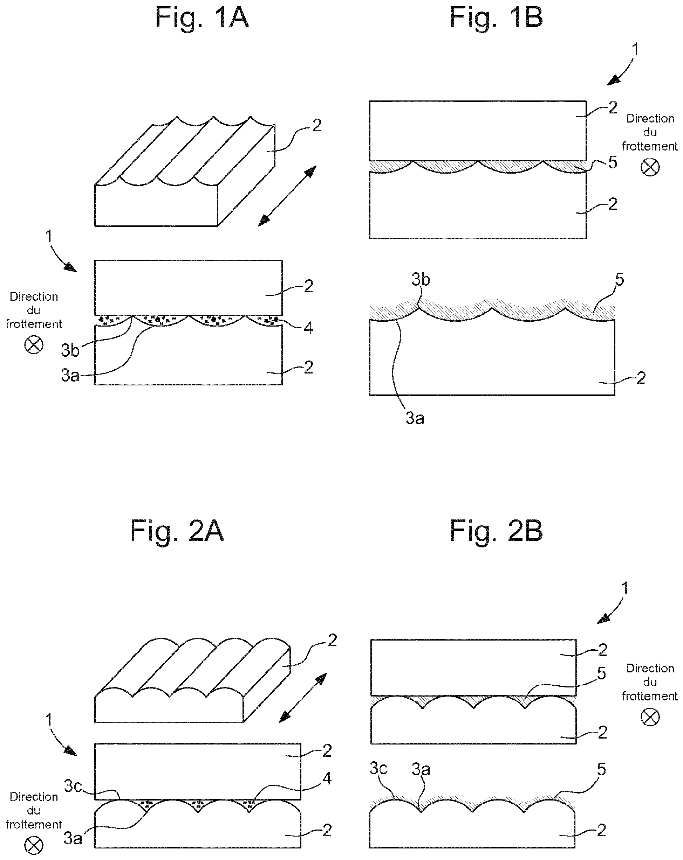

Tel que représenté schématiquement aux figures 1A-2B, au moins un des deux composants 2 du système 1 présente dans la zone fonctionnelle de sa surface de frottement une topologie de surface facilitant, d'une part, l'évacuation des particules du troisième corps et, d'autre part, formant un réservoir pour le lubrifiant.

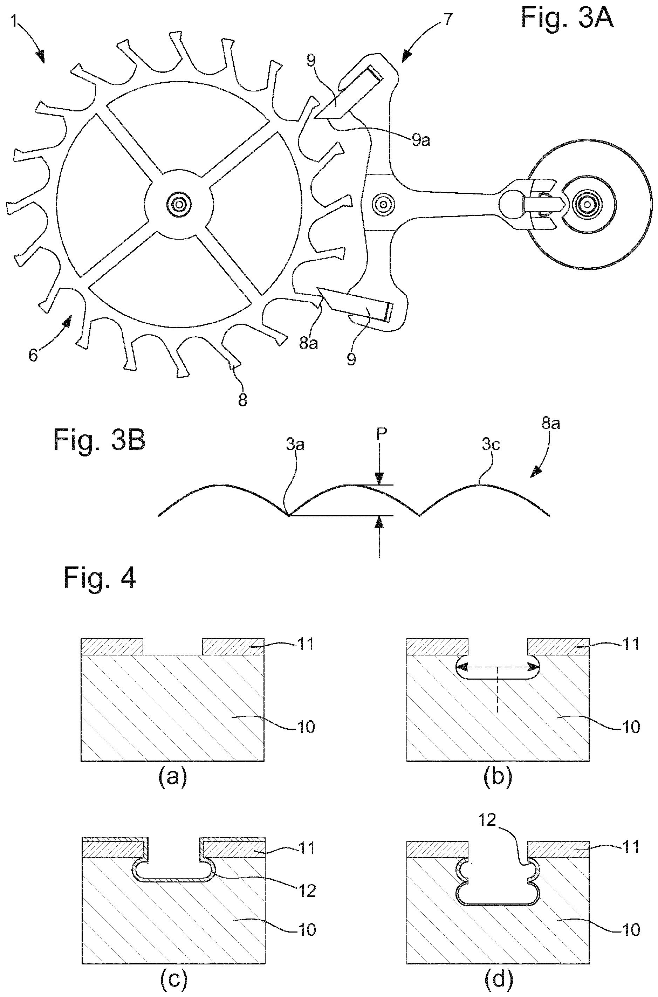

Se référant aux figures 1A et 1B, la topologie de surface est formée de vaguelettes périodiques parallèles entre elles avec des creux 3a, aussi appelée creusures, de forme arrondie séparées par des crêtes 3b. Selon cette variante, le contact entre les deux composants 2 s'établit au niveau des crêtes 3b de la structure. La dimension longitudinale des creusures 3a s'étend parallèlement à la direction du frottement dans la zone fonctionnelle et les creusures servent de réservoirs pour le lubrifiant 5 et de canaux pour l'évacuation des débris 4 de frottement. Selon l'invention, la profondeur P des creusures qui est la distance entre le point bas de la creusure et le sommet de la crête est typiquement supérieure ou égale à 100 nm et inférieure ou égale à 500 nm (fig.3B).

Aux figures 2A et 2B, la structure présente une succession de bosses 3c arrondies séparées par des creusures 3a. Cette structure est obtenue par électroformage de composants métalliques dans des moules présentant la structure en forme de vaguelettes des figures 1A et 1B. La profondeur P des creusures correspond donc ici à la distance entre le point bas de la creusure et le sommet de la bosse et est bien entendu égale à la profondeur P susmentionnée. Selon cette autre variante, le contact entre les deux composants 2 s'établit au niveau du sommet des bosses 3c de la texture.

Dans les variantes présentées aux figures 1A-2B, seul un des deux composants comporte des creusures, l'autre composant présentant dans la zone fonctionnelle une surface de frottement sensiblement lisse. Selon une autre variante non représentée, les deux composants peuvent comporter dans cette zone des creusures en regard l'une de l'autre formant ensemble des canaux d'évacuation des débris et des réservoirs pour le lubrifiant.

A titre illustratif, la figure 3A représente un système horloger 1 : roue d'échappement 6/ancre 7 avec un ou les deux composants 6,7 qui présentent au moins sur la tranche 8a, 9a des dents 8 et/ou des levées 9 soumise au frottement une texture selon l'invention (fig.3B).

Cette texture de surface est obtenue lors de l'usinage du composant ou du moule par le procédé DRIE qui est un procédé de gravure par plasma qui comporte deux cycles différents se succédant, à savoir un cycle de gravure et un cycle de passivation. Le procédé est schématiquement illustré à la figure 4. De manière connue, une ébauche 10 à base de silicium est mise à disposition. Un masque ajouré 11 définissant la tranchée à usiner est formé sur la surface de l'ébauche 10 (fig.4a). Le procédé consiste ensuite en la succession des étapes de gravure (fig.4b) sous un gaz fluoré (par ex. SF₆) et de passivation (couche 12) sous un gaz fluorocarboné (par ex. C₄F₈), l'alternance des étapes de gravure et de passivation générant la structure en vaguelettes sur le flanc usiné. La périodicité et la profondeur des creusures peuvent, de manière connue, être modulées en changeant, entre autres, le temps des séquences de gravure et de passivation. (par exemple 6" de gravure - 2" de passivation, ou 3" de gravure - 1" de passivation), De préférence la durée des phase de gravure sont supérieures aux durées des phase de passivation. Selon l'invention, ces creusures ont une profondeur P comprise entre 100 et 300 nm, de préférence avec une périodicité des creusures comprise entre 1.5 et 6um et de préférence de l'ordre de 3um (micron).

Optionnellement, pour réduire la profondeur des creusures, sans pour autant supprimer la rugosité de surface, une étape d'oxydation suivie d'une désoxydation peut être envisagée (non représentée). Cette étape consiste à réaliser une oxydation thermique à des températures typiquement comprises entre 900 et 1200°C suivie d'une désoxydation chimique typiquement dans de l'acide fluorhydrique. A titre d'exemple, la profondeur P des creusures peut ainsi être réduite de 300 nm à 100-200 nm lors de cette étape.

Ensuite, lorsque le procédé susmentionné est utilisé pour fabriquer un moule, le procédé comporte en outre une étape de dépôt par électroformage d'un alliage métallique sur la face texturée du moule pour réaliser le composant comportant en surface une succession de bosses et de creusures.

### Légende

(1) Système de composants
(2) Composant
(3) Texture dite ondulée
   a) Creusure
   b) Crête
   c) Bosse
(4) Débris
(5) Lubrifiant
(6) Roue d'échappement
(7) Ancre
(8) Dent de la roue d'échappement
   a. Tranche ou flanc
(9) Levée de l'ancre
   a. Tranche ou flanc
(10) Ebauche
(11) Masque
(12) Couche de passivation

## Revendications

1. Système (1) comportant deux composants (2) destinés à être en contact de frottement par des surfaces de frottement l'un par rapport à l'autre selon une direction de frottement donnée, le frottement s'établissant dans une zone dite fonctionnelle, système (1) dans lequel au moins un des deux composants (2) comporte dans la zone fonctionnelle une surface présentant une texture formée d'une succession de creusures (3a) de forme arrondie séparées par des crêtes (3b) ou d'une succession de bosses (3c) de forme arrondie séparées par des creusures (3a), lesdites creusures (3a) s'étendant parallèlement à ladite direction donnée et permettant l'évacuation de débris (4) issus du frottement et faisant office de réservoir pour un lubrifiant (5), système **caractérisé en ce que** lesdites creusures (3a) ont une profondeur P qui est supérieure ou égale à 100 nm et inférieure ou égale à 300 nm.

2. Système (1) selon la revendication 1 **caractérisé en ce que** les creusures (3a) sont longitudinales et parallèles entre elles.

3. Système (1) selon l'une des revendications 1 à 2, **caractérisé en ce que** la succession de creusures (3a) et de crêtes (3b) ou de bosses (3c) et de creusures (3a) forme une structure périodique.

4. Système (1) selon l'une quelconque des revendications précédentes, **caractérisé en ce que** la texture est présente sur un flanc (8a, 9a) dudit au moins composant (2) usiné par gravure ionique réactive profonde.

5. Système (1) selon l'une quelconque des revendications précédentes, **caractérisé en ce que** chacun des deux composants (2) comporte ladite texture sur une surface dans la zone fonctionnelle, lesdites creusures (3a) étant disposées en regard l'une de l'autre.

6. Système (1) selon l'une quelconque des revendications 1 à 4, **caractérisé en ce qu'**un seul desdits deux composants (2) comporte sur sa surface ladite texture, l'autre composant (2) du système (1) présentant une surface lisse dans la zone fonctionnelle.

7. Système (1) selon l'une quelconque des revendications précédentes, **caractérisé en ce que** ledit au moins un composant (2) est à base de silicium ou à base métallique.

8. Système (1) selon l'une quelconque des revendications précédentes, **caractérisé en ce que** les deux composants (2) sont des composants horlogers.

9. Pièce d'horlogerie comprenant le système (1) selon la revendication 8.

10. Moule destiné à réaliser ledit au moins un composant (2) comprenant une succession de bosses (3c) de forme arrondie séparées par des creusures (3a) selon l'une quelconque des revendications 1 à 3 et 5 à 8 quand elles ne dépendent pas de la revendication 4, le moule comportant sur une de ses faces une empreinte avec ladite texture formée d'une succession de creusures (3a) de forme arrondie séparées par des crêtes (3b), lesdites creusures (3a) ayant une profondeur P qui est supérieure ou égale à 100 nm et inférieure ou égale à 300 nm.

11. Procédé de fabrication d'un moule ou d'un composant (2) respectivement à base de silicium, le procédé comprenant les étapes suivantes :
(a) Mise à disposition d'une ébauche (10) à base de silicium,
(b) Usinage de flancs (8a,9a) sur ladite ébauche (10) par la méthode de gravure ionique réactive profonde pour réaliser le moule ou le composant (2), lesdits flancs usinés (8a,9a) présentant une texture en forme de vaguelettes inhérentes à la méthode de gravure ionique réactive profonde, ladite texture définissant sur les flancs usinés (8a,9a) un ensemble de creusures (3a) d'une profondeur P, ledit procédé étant **caractérisé en ce qu'**à l'issue du procédé de fabrication, lesdites creusures (3a) sont maintenues sur les flancs usinés (8a,9a) du moule ou du composant (2) de manière à former sur lesdits flancs usinés (8a,9a) des canaux aptes à collecter des débris (4) ou à recevoir un lubrifiant (5) et **en ce que** lesdits flans sont usinés de sorte que lesdites creusures (3a) présentent une profondeur P qui est supérieure ou égale à 100 nm et inférieure ou égale à 300 nm.

12. Procédé selon la revendication 11, **caractérisé en ce que** l'étape d'usinage (b) est suivie d'une étape d'oxydation et de désoxydation (c) permettant de réduire la profondeur P des creusures (3a), la profondeur P étant maintenue à une valeur supérieure ou égale à 100 nm à l'issue de ladite étape (c).

13. Procédé selon la revendication 11 ou 12 pour la fabrication d'un moule, **caractérisé en ce qu'**il comporte après l'étape (b) ou l'étape (c), une étape de dépôt par électroformage d'un alliage métallique sur les flancs usinés (8a, 9a) du moule pour réaliser un autre composant (2).

## Patentansprüche

1. System (1) mit zwei Komponenten (2), die dazu bestimmt sind, über Reibflächen miteinander in Reibkontakt zu stehen und sich relativ zueinander entlang einer vorgegebenen Reibrichtung zu bewegen, wobei der Reibkontakt in einem sogenannten Funktionsbereich erfolgt, wobei in dem System (1) mindestens eine der beiden Komponenten (2) in dem Funktionsbereich eine Oberfläche mit einer Textur aufweist, die aus einer Abfolge von Vertiefungen (3a) mit abgerundeter Form, die durch Grate (3b) voneinander getrennt sind, oder aus einer Abfolge von Erhebungen (3c) mit abgerundeter Form, die durch Vertiefungen (3a) voneinander getrennt sind, gebildet ist, wobei sich die Vertiefungen (3a) parallel zu der vorgegebenen Reibrichtung erstrecken und das Abführen von durch die Reibung erzeugten Abriebpartikeln (4) ermöglichen sowie als Reservoir für ein Schmiermittel (5) dienen, **dadurch gekennzeichnet, dass** die Vertiefungen (3a) eine Tiefe P aufweisen, die größer oder gleich 100 nm und kleiner oder gleich 300 nm ist.

2. System (1) nach Anspruch 1, **dadurch gekennzeichnet, dass** die Vertiefungen (3a) längs verlaufen und parallel zueinander sind.

3. System (1) nach einem der Ansprüche 1 bis 2, **dadurch gekennzeichnet, dass** die Abfolge von Vertiefungen (3a) und Graten (3b) oder von Erhebungen (3c) und Vertiefungen (3a) eine periodische Struktur bildet.

4. System (1) nach einem der vorhergehenden Ansprüche, **dadurch gekennzeichnet, dass** die Textur auf einer durch tiefes reaktives Ionenätzen bearbeiteten Flanke (8a, 9a) der mindestens einen Komponente (2) vorhanden ist.

5. System (1) nach einem der vorhergehenden Ansprüche, **dadurch gekennzeichnet, dass** jede der beiden Komponenten (2) die Textur auf einer Oberfläche in dem Funktionsbereich aufweist, wobei die Vertiefungen (3a) einander gegenüberliegend angeordnet sind.

6. System (1) nach einem der Ansprüche 1 bis 4, **dadurch gekennzeichnet, dass** nur eine der beiden Komponenten (2) auf ihrer Oberfläche die Textur aufweist, während die andere Komponente (2) des Systems (1) in dem Funktionsbereich eine glatte Oberfläche aufweist.

7. System (1) nach einem der vorhergehenden Ansprüche, **dadurch gekennzeichnet, dass** die mindestens eine Komponente (2) aus einem siliziumbasierten oder metallbasierten Material besteht.

8. System (1) nach einem der vorhergehenden Ansprüche, **dadurch gekennzeichnet, dass** die beiden Komponenten (2) Uhrwerkskomponenten sind.

9. Uhrmacherteil mit dem System (1) nach Anspruch 8.

10. Form zur Herstellung der mindestens einen Komponente (2) mit einer Abfolge von Erhebungen (3c) mit abgerundeter Form, die durch Vertiefungen (3a) voneinander getrennt sind, nach einem der Ansprüche 1 bis 3 und 5 bis 8, sofern diese nicht von Anspruch 4 abhängig sind, wobei die Form auf einer ihrer Flächen einen die Textur wiedergebenden Abdruck aufweist, der aus einer Abfolge von Vertiefungen (3a) mit abgerundeter Form, die durch Grate (3b) voneinander getrennt sind, gebildet ist, wobei die Vertiefungen (3a) eine Tiefe P aufweisen, die größer oder gleich 100 nm und kleiner oder gleich 300 nm ist.

11. Verfahren zur Herstellung einer auf Siliziumbasis ausgebildeten Form oder Komponente (2), wobei das Verfahren die folgenden Schritte umfasst:
(a) Bereitstellung eines Rohlings (10) auf Siliziumbasis,
(b) Bearbeitung von Flanken (8a, 9a) an dem Rohling (10) mittels des Verfahrens des tiefen reaktiven Ionenätzens zur Herstellung der Form oder der Komponente (2), wobei die bearbeiteten Flanken (8a, 9a) eine dem Verfahren des tiefen reaktiven Ionenätzens inhärente wellenförmige Textur aufweisen, wobei die Textur auf den bearbeiteten Flanken (8a, 9a) eine Gesamtheit von Vertiefungen (3a) einer Tiefe P definiert, wobei das Verfahren **dadurch gekennzeichnet ist, dass** am Ende des Herstellungsverfahrens die Vertiefungen (3a) auf den bearbeiteten Flanken (8a, 9a) der Form oder der Komponente (2) beibehalten werden, so dass sie auf den bearbeiteten Flanken (8a, 9a) Kanäle bilden, die geeignet sind, Abriebpartikel (4) zu sammeln oder ein Schmiermittel (5) aufzunehmen, und dass die Flanken so bearbeitet werden, dass die Vertiefungen (3a) eine Tiefe P aufweisen, die größer oder gleich 100 nm und kleiner oder gleich 300 nm ist.

12. Verfahren nach Anspruch 11, **dadurch gekennzeichnet, dass** auf den Bearbeitungsschritt (b) ein Oxidations- und Desoxidationsschritt (c) folgt, durch den die Tiefe P der Vertiefungen (3a) verringert wird, wobei die Tiefe P am Ende des Schritts (c) auf einem Wert von mindestens 100 nm gehalten wird.

13. Verfahren nach Anspruch 11 oder 12 zur Herstellung einer Form, **dadurch gekennzeichnet, dass** es nach Schritt (b) oder Schritt (c) einen Schritt der Galvanoformung einer Metalllegierung auf den bearbeiteten Flanken (8a, 9a) der Form umfasst, um eine weitere Komponente (2) herzustellen.

## Claims

1. System (1) comprising two components (2) designed to contact each other along friction surfaces in a given direction of friction, the friction occurring in a so-called functional zone, at least one of the two components (2) of the system (1) comprising, in the functional zone, a surface having a texture formed by a series of rounded recesses (3a) separated by ridges (3b) or of a series of rounded bosses (3c) separated by said recesses (3a), said recesses (3a) extending parallel to said given direction and enabling friction debris (4) to be removed and acting as a reservoir for a lubricant (5), the system being **characterised in that** said recesses (3a) have a depth P that is greater than or equal to 100 nm and less than or equal to 300 nm.

2. System (1) according to claim 1, **characterised in that** the recesses (3a) are longitudinal and parallel to each other.

3. System (1) according to any of claims 1 to 2, **characterised in that** the series of recesses (3a) and of ridges (3b) or of bosses (3c) and of recesses (3a) forms a periodic structure.

4. System (1) according to any of the preceding claims, **characterised in that** the texture is present on one side (8a, 9a) of said at least one component (2) machined by deep reactive ion etching.

5. System (1) according to any of the preceding claims, **characterised in that** each of the two components (2) comprises said texture on a surface in the functional zone, with said recesses (3a) being arranged facing each other.

6. System (1) according to any of claims 1 to 4, **characterised in that** only one of the two components (2) comprises said texture on its surface, the other component (2) of the system (1) having a smooth surface in the functional zone.

7. System (1) according to any of the preceding claims, **characterised in that** the at least one component (2) is silicon-based or metal-based.

8. System (1) according to any of the preceding claims, **characterised in that** the two components (2) are horological components.

9. Timepiece comprising the system (1) according to claim 8.

10. Mould for forming said at least one component (2) comprising a series of rounded bosses (3c) separated by recesses (3a) according to any of claims 1 to 3 and 5 to 8 where they do not depend on claim 4, the mould comprising, on one of its faces, an impression with said texture formed by a series of rounded recesses (3a) separated by ridges (3b), said recesses (3a) having a depth P that is greater than or equal to 100 nm and less than or equal to 300 nm.

11. Method for manufacturing a silicon-based mould or a silicon-based component (2), respectively, the method comprising the following steps:
(a) Preparing a silicon-based ebauche (10),
(b) Machining sides (8a, 9a) on said ebauche (10) using the deep reactive ion etching method to produce the mould or component (2), said machined sides (8a, 9a) having a rippled texture inherent to the deep reactive ion etching method, said texture defining on the machined sides (8a, 9a) a set of recesses (3a) with a depth P, said method being **characterised in that**, at the end of the manufacturing process, said recesses (3a) are left on the machined sides (8a, 9a) of the mould or of the component (2) so as to form on said machined sides (8a, 9a) channels capable of collecting debris (4) or containing a lubricant (5), and **in that** said sides are machined such that said recesses (3a) have a depth P that is greater than or equal to 100 nm and less than or equal to 300 nm.

12. Method according to claim 11, **characterised in that** the machining step (b) is followed by an oxidation and deoxidation step (c) that reduces the depth P of the recesses (3a), the depth P being maintained at a value greater than or equal to 100 nm at the end of said step (c).

13. Method according to claim 11 or 12 for manufacturing a mould, **characterised in that** it comprises, after step (b) or step (c), a step for depositing a metallic alloy onto the machined sides (8a, 9a) of the mould by electroforming in order to produce another component (2).
